**Europäisches Patentamt**

**European Patent Office**

**Office européen des brevets**

(19)

(11) Numéro de publication : **0 477 051 B1**

(12) **FASCICULE DE BREVET EUROPEEN**

(45) Date de publication du fascicule du brevet :
27.09.95 Bulletin 95/39

(51) Int. Cl.⁶ : **H02K 23/18,** H01R 39/44,
G01R 31/34

(21) Numéro de dépôt : **91402286.8**

(22) Date de dépôt : **21.08.91**

(54) **Dispositif de réglage de la ligne neutre d'un moteur électrique.**

(30) Priorité : **21.09.90 FR 9011692**

(43) Date de publication de la demande :
**25.03.92 Bulletin 92/13**

(45) Mention de la délivrance du brevet :
**27.09.95 Bulletin 95/39**

(84) Etats contractants désignés :
**DE GB IT**

(56) Documents cités :
**US-A- 2 117 035**
**US-A- 2 450 897**
**US-A- 2 752 568**
**US-A- 3 480 813**

(73) Titulaire : **AUTOMOBILES PEUGEOT**
**75, avenue de la Grande Armée**
**F-75116 Paris (FR)**
Titulaire : **AUTOMOBILES CITROEN**
**62 Boulevard Victor-Hugo**
**F-92200 Neuilly-sur-Seine (FR)**

(72) Inventeur : **Bouton, Joel**
**28, Route de Pierrelaye**
**F-95610 Eragny-sur-Oise (FR)**

(74) Mandataire : **Berger, Helmut et al**
**Cabinet Z. WEINSTEIN**
**20, avenue de Friedland**
**F-75008 Paris (FR)**

EP 0 477 051 B1

## Description

La présente invention concerne un dispositif de réglage de la ligne neutre d'un moteur électrique.

Dans les machines électriques notamment à courant continu, du type comprenant un inducteur fixe ou stator, un induit ou rotor tournant à l'intérieur du stator, un ensemble collecteur-balais permettant de recueillir une force électromotrice, les lignes neutres théoriques sont des axes de symétrie électromagnétiques décalés d'un angle de $\frac{\pi}{2\rho}$ par rapport à l'axe des pôles principaux du stator, où p est le nombre de paires de pôles. Un réglage de la position de la couronne portant les balais fixes, qui frottent le collecteur en rotation, sur la ligne neutre théorique permet d'obtenir une meilleure commutation possible. Un tel réglage est d'importance primordiale car une mauvaise commutation entraîne une usure prématurée du collecteur ainsi que des balais et a une influence sur les performances du moteur électrique.

Le réglage de la ligne neutre peut être effectué à l'aide d'un marteau et d'un outil, du genre burin, sur lequel on tape pour obtenir un déplacement dans un sens ou dans l'autre autour de l'axe moteur de la couronne porte-balais. De tels moyens de réglage sont bien entendu peu précis et peu pratiques.

Le document US-A-2 117 035 décrit un générateur de courant dont le carter est conçu à l'origine pour porter un dispositif à tige filetée immobilisée en translation et pouvant être entraînée en rotation par une manivelle pour entraîner en translation un cavalier fixé sur une couronne porte-balais qui peut ainsi être réglée à une position angulaire souhaitée.

Cependant, ce dispositif de réglage connu de la position angulaire de la couronne porte-balais est encombrant puisque fixé à demeure au carter du générateur de courant et il faut prévoir autant de tels dispositifs qu'il y a de générateurs de courant, ce qui est coûteux.

La présente invention a pour but d'éliminer les inconvénients ci-dessus des dispositifs connus en proposant un dispositif de réglage de la ligne neutre d'un moteur électrique tel que défini dans la revendication 1.

La pièce d'accouplement comprend une tête d'accouplement de la tige filetée prolongée par l'axe tourillonnant précité.

La tige filetée est maintenue en translation à la pièce d'accouplement par deux anneaux d'arrêt ou circlips.

La partie formant écrou est fixée amoviblement au palier collecteur par l'intermédiaire d'une vis de fixation.

La tige filetée est du type micrométrique.

La tige filetée comprend une tête de manoeuvre ou, selon une variante, comporte un bouton de manoeuvre gradué.

L'invention sera mieux comprise, et d'autres buts, détails et avantages de celle-ci apparaîtront plus au cours de la description explicative qui va suivre faite en référence aux dessins schématiques annexés donnés uniquement à titre d'exemple illustrant un mode de réalisation de l'invention, et dans lesquels :

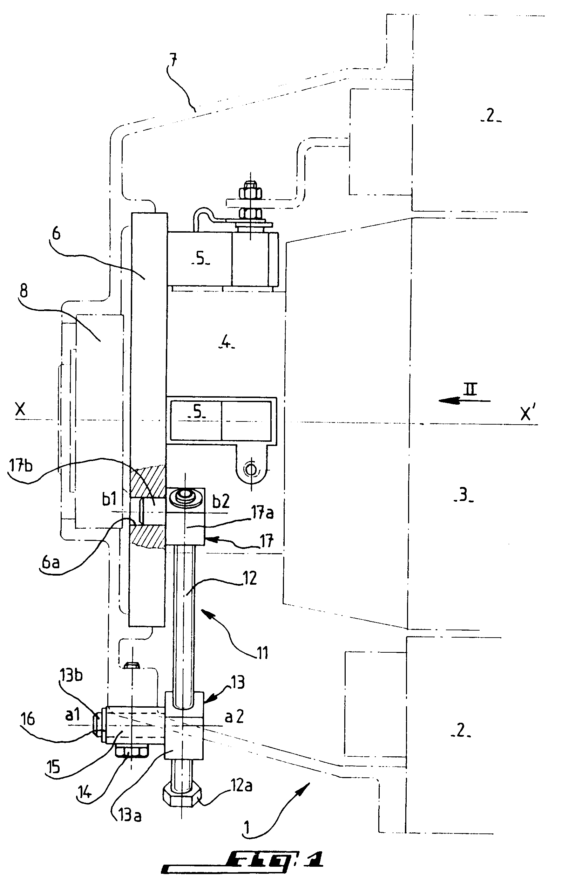

La figure 1 est une vue latérale du dispositif de réglage conforme à l'invention monté sur un moteur électrique ;

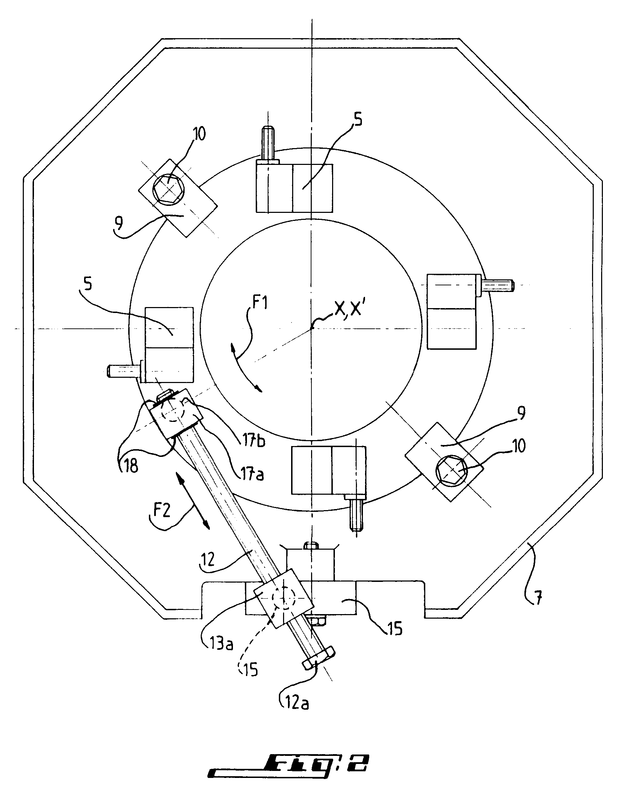

La figure 2 est une vue suivant la flèche II de la figure 1.

En se reportant aux figures, la référence 1 désigne un moteur électrique, partiellement représenté, tel qu'un moteur à courant continu, comprenant essentiellement un inducteur fixe ou stator 2, un induit ou rotor 3 tournant à l'intérieur du stator 2, un collecteur rotatif 4 solidaire du rotor 3, des balais fixes 5 en contact frottant sur le collecteur 4 et une couronne 6 de support des balais 5. Le collecteur 4 est monté rotatif par son extrémité opposée à celle reliée au rotor 3 dans un palier de support 7 par l'intermédiaire d'un roulement par exemple à billes 8.

Le palier de support 7 ou palier collecteur, solidarisé au stator 2 par l'intermédiaire de vis de fixation (non représentées), supporte également la couronne porte-balais 6 qui est solidarisée au palier 7 à l'aide d'au moins une paire de moyens de fixation diamétralement opposés comprenant chacune une patte de fixation 9 et une vis de fixation 10.

Les balais fixes 5 sont disposés de telle sorte qu'ils recueillent la tension des sections du collecteur embrassant le maximum de flux. Cette position particulière est la ligne neutre.

Le dispositif de l'invention permettant le réglage de la ligne neutre des balais 5 ou de la couronne porte-balais 6 comprend un outil 11 monté sur le moteur électrique 1 de façon à régler la position angulaire de la couronne porte-balais 6 autour de l'axe moteur X-X' et donc autour du collecteur 4, comme indiqué par la double flèche F1.

L'outil 11 comprend une tige filetée ou vis 12, de préférence micrométrique, à tête de manoeuvre hexagonale 12a et pouvant se déplacer longitudinalement lorsqu'entraînée en rotation dans une partie formant écrou 13 amoviblement fixée par des vis de fixation 14 au palier collecteur 7 tout en étant articulée autour d'un axe a1-a2 parallèle à l'axe X-X'. Pour cela, l'écrou proprement dit 13a de la partie 13 est solidaire d'un axe 13b monté librement rotatif dans une pièce formant manchon 15 solidarisée au palier 7 par la vis 14. L'axe 13b est maintenu axialement dans la pièce 15 par un anneau d'arrêt ou circlips 16. La tige filetée 12 est de plus accouplée, au voisinage de son extrémité opposée à la tête 12a, à la couronne porte-balais 6 par une pièce d'accouplement 17 montée articulée à la couronne 6 autour d'un axe b1-b2 parallèle à l'axe a1-a2. La pièce d'accouplement 17 comprend une tête 17a traversée par la tige filetée 12 et un axe 17b prolongeant la tête 17a et s'engageant dans un alésage ou perçage correspondant 6a de la couronne 6 de façon à y être librement tournant. La tige filetée 12 est immobilisée en translation relativement à la tête 17a par deux anneaux d'arrêt ou circlips 18 situés de part et d'autre de la tête 17a, tout en pouvant tourner librement dans la tête 17a. La tige filetée 12 est ainsi montée sur le moteur 1 de façon perpendiculaire à l'axe X-X' et donc parallèlement à la couronne porte-balais 6 de manière qu'à un déplacement longitudinal de la tige filetée 12 comme symbolisé par la double flèche F2 relativement à la partie formant écrou 13 corresponde une rotation suivant la flèche F1 de la couronne porte-balais 6 autour de l'axe moteur X-X', le déplacement longitudinal étant bien entendu obtenu en manoeuvrant à l'aide d'une clé la tête 12a de la tige 12.

Le dispositif de réglage conforme à l'invention permet ainsi un réglage très précis de la ligne neutre du moteur électrique, d'où une commutation optimisée en décalant angulairement la position de la couronne 6 relativement au collecteur 4 et quelque soit le mode de fonctionnement, à vide ou en charge, du moteur. Du fait que l'outil 11 est montable et démontable respectivement avant et après chaque réglage de lignes neutres, celui-ci peut servir pour le réglage de lignes neutres d'une série de moteurs. De plus, la tête de vis 12a peut être remplacée par un bouton gradué de façon qu'un opérateur puisse régler très précisément la ligne neutre du moteur électrique à une valeur souhaitée.

## Revendications

1. Dispositif de réglage de la ligne neutre d'un moteur électrique comprenant un rotor (3), un stator (2), un collecteur rotatif (4), un palier collecteur (7), une couronne porte-balais (6) et un outil (11) monté sur le moteur électrique (1) de façon à permettre un réglage direct de la position angulaire de la couronne porte-balais (6) relativement à l'axe moteur (X-X'), caractérisé en ce que l'outil de réglage (11) est démontable du moteur électrique (1) et comprend une tige filetée (12) déplaçable dans une partie formant écrou (13) montée articulée autour d'un axe (a1-a2) parallèle à l'axe moteur (X-X') et fixée amoviblement au palier collecteur (7) et en ce que la tige filetée (12) est accouplée, au voisinage de son extrémité opposée à la partie formant écrou (13), à la couronne porte-balais (6) de façon articulée autour d'un axe (b1-b2) parallèle à l'axe moteur (X-X') par une pièce d'accouplement (17) comprenant un axe (17b) tournant librement dans un perçage (6a) de la couronne porte-balais (6) et dans laquelle est montée rotative la tige filetée (12) tout en y étant solidarisée en translation, de sorte qu'un déplacement longitudinal de la tige filetée relativement à la partie formant écrou (13), s'accompagne d'une rotation de la couronne porte-balais (6) autour de l'axe moteur (1).

2. Dispositif selon la revendication 1, caractérisé en ce que la pièce d'accouplement (17) comprend une tête d'accouplement (17a) de la tige filetée (12) prolongée par l'axe tourillonnant (17b) précité.

3. Dispositif selon la revendication 1 ou 2, caractérisé en ce que la tige filetée (12) est maintenue en translation à la pièce d'accouplement (17) par deux anneaux d'arrêt ou circlips (18).

4. Dispositif selon l'une des revendications précédentes, caractérisé en ce que la partie formant écrou (13) est fixée amoviblement au palier collecteur (7) par l'intermédiaire d'une vis de fixation (14).

5. Dispositif selon l'une des revendications précédentes, caractérisé en ce que la tige filetée (12) est du type micrométrique.

6. Dispositif selon l'une des revendications 1 à 5, caractérisé en ce que la tige filetée (12) comprend une tête de manoeuvre (12a).

7. Dispositif selon l'une des revendications 1 à 5, caractérisé en ce que la tige filetée (12) comporte un bouton de manoeuvre gradué.

## Patentansprüche

1. Vorrichtung zur Einstellung der Neutrallinie eines elektrischen Motors mit einem Rotor (3), einem Stator ( 2), einem drehbaren Kollektor (4), einem Kollektorlager (7), einem Schleifbürstentragring (6) und einem an dem elektrischen Motor (1) angeordneten Werkzeug (11), um das unmittelbare Einstellen der Winkelstellung des Schleifbürstentragringes (6) in bezug auf die Motorachse (X-X') zu gestatten, dadurch gekennzeichnet, dass das Regelwerkzeug (11) von dem elektrischen Motor (1) abnehmbar ist und eine Schraubenspindel (12) aufweist, die in einem um eine zur Motorachse (X-X') parallele Achse (a1-a2) angelenkten und an dem Kollektorlager (7) lösbar befestigten eine Mutter bildenden Teil (13) verschiebbar ist und dass die Schraubenspindel (12) in dem Bereich ihres dem eine Mutter bildenden Teil (13) entgegengesetzten Endes an dem Schleifbürstentragring (6) in gelenkiger Weise um eine zur Motorachse (X-X') parallele Achse (b1-b2) herum durch ein Kupplungsstück (17) angekuppelt ist, welches einen in einer Bohrung (6a) des Schleifbürstentragringes (6) frei drehbaren Zapfen (17b) aufweist und in welchem Kupplungsstück die Schraubenspindel (12) drehbar angeordnet ist, während sie darin translationsbewegungsfest ist, so dass eine Längsverschiebung der Schraubenspindel in bezug auf den eine Mutter bildenden Teil (13) durch eine Drehung des Schleifbürstentragringes (6) um die Achse des Motors (1) herum begleitet wird.

2. Vorrichtung nach Anspruch 1, dadurch gekennzeichnet, dass das Kupplungsstück (17) einen durch den vorgenannten Drehzapfen (17b) verlängerten Kopf (17a) zum Ankuppeln der Schraubenspindel (12) umfasst.

3. Vorrichtung nach Anspruch 1 oder 2, dadurch gekennzeichnet, dass die Schraubenspindel (12) in Translationsbewegung an dem Kupplungsstück (17) durch zwei Sicherungs- bzw. Sperrringe (18) gehalten wird.

4. Vorrichtung nach einem der vorangehenden Ansprüche, dadurch gekennzeichnet, dass der eine Mutter bildende Teil (13) über eine Befestigungsschraube (14) an dem Kollektorlager (7) abnehmbar befestigt ist.

5. Vorrichtung nach einem der vorangehenden Ansprüche, dadurch gekennzeichnet, dass die Schraubenspindel (12) der mikrometrischen Bauart ist.

6. Vorrichtung nach einem der Ansprüche 1 bis 5, dadurch gekennzeichnet, dass die Schraubenspindel (12) einen Betätigungskopf (12a) aufweist.

7. Vorrichtung nach einem der Ansprüche 1 bis 5, dadurch gekennzeichnet, dass die Schraubenspindel (12) einen Betätigungsskalenkopf aufweist.

**Claims**

1. Device for adjusting the neutral line of an electric motor comprising a rotor (3), a stator (2), a rotary collector-ring (4), a collector-ring bearing (7), a brush-carrying ring (6) and a tool (11) mounted onto the electric motor (1) so as to permit a direct adjustment of the angular position of the brush-carrying ring (6) in relation to the motor axis (X-X'), characterized in that the adjustment tool (11) is removable from the electric motor (1) and comprises a threaded rod (12) displaceable in a nut-like part (13) pivotally mounted about an axis (a1-a2) parallel to the motor axis (X-X') and removably fastened to the slip-ring bearing (7) and in that the threaded rod (12) is coupled in the viscinity of its end opposite to the nutlike part (13) to the brush-carrying ring (6) in a pivotal fashion about an axis (b1-b2) parallel to the motor axis (X-X') by a coupling member (17) comprising a pin (17b) turning freely in a bore (6a) of the brush-carrying ring (6) and in which the threaded rod is rotatably mounted while being made translatory motion-bound therein so that a longitudinal displacement of the threaded rod in relation to the nut-like part (13) is attended by a rotation of the brush-carrying ring (6) about the axis of the motor (1).

2. Device according to claim 1, characterized in that the coupling member (17) comprises a head (17a) for the coupling of the threaded rod (12) extended by the aforesaid journalled pin (17b).

3. Device according to claim 1 or 2, characterized in that the threaded rod (12) is held for translatory motion to the coupling member (17) by two stop rings or circlips (18).

4. Device according to one of the foregoing claims, characterized in that the nut-like part (13) is removably fastened to the slip-ring bearing (7) through the medium of a fastening screw (14).

5. Device according to one of the foregoing claims, characterized in that the threaded rod (12) is of the micrometric type.

6. Device according to one of claims 1 to 5, characterized in that the threaded rod (12) comprises an operating head (12a).

7. Device according to one of claims 1 to 5, characterized in that the threaded rod (12) comprises a graduated control knob.

Fig. 1

Fig. 2